# EUROPEAN PATENT SPECIFICATION

(11) **EP 1 431 834 B1**
(45) Date of publication and mention of the grant of the patent: **23.07.2008**
(21) Application number: 03258011.0
(22) Date of filing: 18.12.2003
(51) Int. Cl.: G03F 9/00

(54) **A device manufacturing method using a lithographic projection mask**
Verfahren zur Herstellung eines Artikels unter Verwendung einer lithographischen Projektionsmaske
Méthode de fabrication d'un dispositif utilisant un masque de projection lithographique

(30) Priority: 19.12.2002 EP 02258762
(43) Date of publication of application: 23.06.2004
(73) Proprietor: ASML Netherlands B.V., 5504 DR Veldhoven (NL)
(72) Inventor: Best, Keith Frank, Prunedale, California 93907 (US); Consolini, Joseph J., Costa Mesa, California 92626 (US); Friz, Alexander, San Jose, California 95130 (US)
(74) Representative: Leeming, John Gerard

(56) References cited:
- EP-A- 0 466 335
- EP-A- 1 367 447
- US-A- 4 657 379
- US-A- 4 741 622
- US-A- 5 440 138
- US-A- 5 715 063
- PATENT ABSTRACTS OF JAPAN vol. 2002, no. 09, 4 September 2002 (2002-09-04) & JP 2002 134397 A (SONY CORP), 10 May 2002 (2002-05-10)

## Description

The present invention relates to a device manufacturing method comprising the steps of: providing a substrate that is at least partly covered by a layer of radiation-sensitive material; providing a projection beam of radiation using a radiation system; providing at least one patterning means including a device pattern and at least one reference mark; using said at least one patterning means to endow the projection beam with said device pattern; projecting the patterned beam of radiation onto a plurality of target portions of the layer of radiation sensitive material to create a corresponding pattern in each of said plurality of target portions; determining relative placement of two of said corresponding patterns by measuring alignment of said at least one reference mark of said two of said corresponding patterns.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
A programmable mirror array. One example of such a device is a matrix-addressable surface having a viscoelastic control layer and a reflective surface.

The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096.. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792..

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Generally the radiation beam in a lithography apparatus is only large enough to expose small parts of the wafer at a time. Two methods are used to overcome this so that the whole of the wafer may be exposed. The first is the so called scan mode in which the mask and substrate are moved simultaneously so that a large portion of the substrate can be exposed. The second is step mode in which an entire mask image is projected in one go onto a target portion of the substrate and the substrate is then shifted so that a different portion can then be exposed to the radiation beam. The portions exposed on the substrate table can either be partially overlapping or be abutting. In both overlapping and abutting cases it is clearly desirable to have the portions as well aligned as possible to maximize use of space on the substrate and therefore maximize throughput. Some devices being manufactured cover several target portions and alignment of these target portions becomes critical to ensure correct functioning of the device. In this case the same or different masks may be used for adjacent target portions.

Box-in-box or similar metrologies rely on a particular relative placement of 2 concentric boxes or similar features (sized between 5µm - 100µm) to determine registration errors. This is done by measuring the relative positions of the said features printed during different process steps. Similarly, this method can be used to measure relative placement/registration errors of adjacent dies or fields by overlapping them such that the necessary features have the correct relative placement that is needed for the measurement. An example of a box-in-box type metrology is given in JP 2002-134,397.

The disadvantages of this method are that true field butting or stitching cannot be quantified as the fields must be overlapped and the region of interest is different than the region that is being used for the metrology. In other words, the area where the metrology features are placed in the overlap region not where the device is actually being stitched.

US 5,440,138 discloses a plurality of reticles each having two alignment mark images and an identical or a different pattern image. First, the two alignment mark images and the pattern image of the first reticle are exposed on a first shot area on a wafer. Next, when exposing the two alignment mark images and the pattern image of the second reticle on a second shot area adjacent to the first shot area, the exposed two alignment mark images on the first shot area are detected to adjust the wafer and the second reticle based on the result of the detection such that the exposed pattern images on the first and second shot areas are joined correctly. Thus, the pattern images of the left reticles are also exposed successively with the exposed adjacent pattern images joined. Preferably, after each detection, the detected two alignment mark images are deleted by the double exposure.

EP-A2-0,466,335 discloses a method in accordance with the pre-characterizing portion of claim 1.

It is an object of the present invention to overcome the above disadvantages and provide an improved method of determining relative placement of a plurality of patterns developed on a substrate.

This and other objects are achieved according to the invention in a method as specified in the opening paragraph, characterized in that said at least one reference mark is within said device pattern.

Thus the method can be used to measure alignment of abutted device patterns. As a consequence the accuracy of the placement error can be more accurately assessed. Also the invention can be used with overlapping device patterns.

This system has the advantage at the determining step can be carried out in an existing lithographic projection apparatus which generally already comprises alignment systems to measure alignments of other components in the lithographic projection apparatus. Thus, the degree of alignment and necessary correction can be measured directly in the lithographic projection apparatus and the results can be fed back such that the next wafer is stepped differently to account for the measured misalignment and so that the efficiency with which corrections are made is increased. If the device to be manufactured extends over several target portions, the method acts as a quality control step to ensure the device will function correctly. If misalignment is detected, the resist may be removed and the process carried out again until the correct alignment is achieved.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a lithographic device pattern according to a mask of the present invention;
Figure 3 depicts a plurality of developed patterns on a substrate surface;
Figure 4 illustrates measurement of misalignment of adjacent patterns on a substrate surface; and
Figure 5 illustrates a reference mark according to the present invention.

In the Figures, corresponding reference symbols indicate corresponding parts.

### Embodiment 1

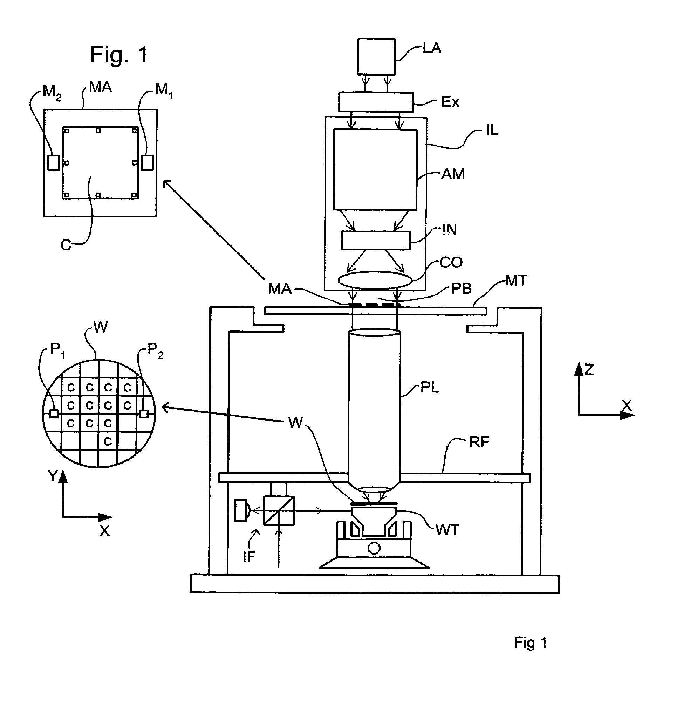

Figure 1 schematically depicts a lithographic projection apparatus according to a particular embodiment of the invention. The apparatus comprises:
· a radiation system Ex, IL, for supplying a projection beam PB of radiation (*e.g.* UV, DUV or EUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g*. a refractive) for imaging an irradiated device pattern DP of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g*. with a reflective mask). Alternatively, the apparatus may employ another kind of patterning means, such as a programmable mirror array of a type as referred to above.

The source LA (*e.g.* an Hg lamp) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g*. the y direction) with a speed *v*, so that the projection beam PB is caused to scan over a mask image; concurrently, the substrate table WT is simultaneously moved in the same or opposite direction at a speed *V=Mv*, in which *M* is the magnification of the lens PL (typically, *M* = 1/4 or 1/5). In this manner, a relatively large target portion C can be exposed, without having to compromise on resolution.

This invention is primarily concerned with the step mode in which a plurality of target portions C on the substrate W are exposed in sequence. In order to maximize the surface area used on the substrate and therefore the efficiency of the process, the target portions are aligned so that they either abut or so that they overlap by small amounts (so called pattern stitching). This sort of process can only be effective if the target portions C are accurately positioned relative to one another. The present invention is directed to a method of determining the alignments of neighbouring target portions so that the step mode can be optimized.

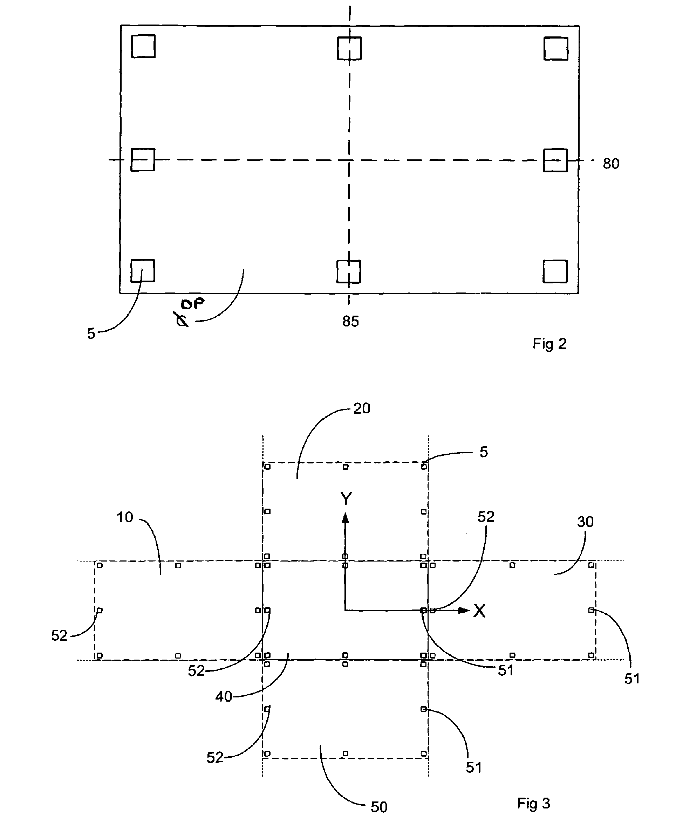

In the present invention the mask MA has a device pattern DP on it (see Figure 2 in which the details of the device are not illustrated) which is intended to be projected onto the target portions C of the substrate W. The device pattern DP of the mask MA comprises at least one reference mark 5 which is projected but which does not form a working part of the final manufactured device. The reference mark 5 is used to determine the relative placement of target portions C as described below. The reference mark 5 is within the device pattern, that is, parts of the device pattern of the mask completely surround the reference mark on all sides of the reference mark 5 and the reference mark 5 is not merely at the edge of the device pattern.

As can be seen in Figure 3, when a substrate W has been exposed by the step mode a plurality of patterns corresponding to the device pattern DP of the mask MA shown in Figure 2 are first projected onto a target portion C on a radiation sensitive material on a surface of the substrate which is then developed to form a plurality of developed patterns 10, 20, 30, 40, 50. These patterns 10, 20, 30, 40, 50 may either abut as illustrated or may overlap slightly as described above. The relative alignment of the patterns in the XY directions in the plane of the surface of the substrate can be determined by measuring alignment of the at least one reference mark 5, 51, 52 of respective developed patterns 10, 20, 30, 40, 50.

The adjacent development patterns 10, 20, 30, 40, 50 need not be of the same type, especially if a single device to be manufactured extends over several target portions. In this case different masks having different device patterns DP will be used but adjacent device patterns will need to include compatably placed alignment marks 5. The alignment marks 5 are completely within the development patterns 10, 20, 30, 40, 50.

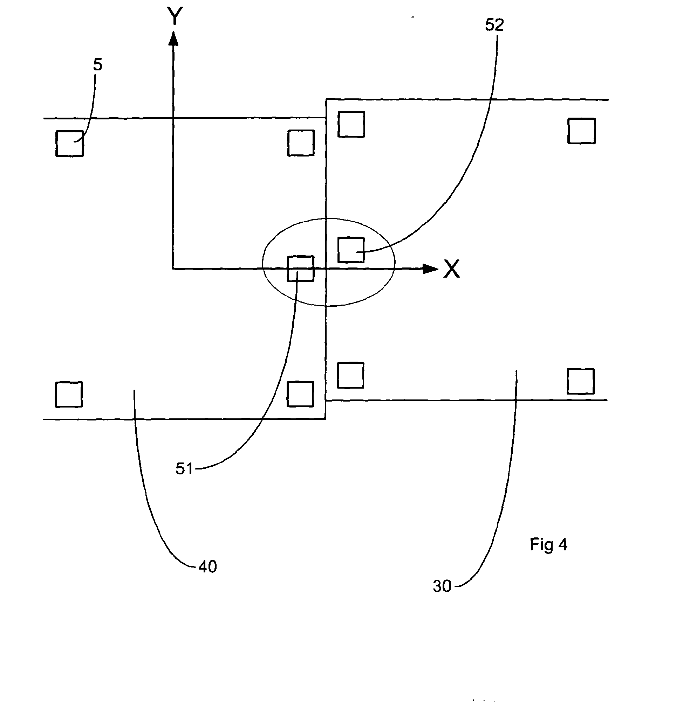

Figure 4 shows in detail the measurement of misalignment of two adjacent developed patterns 30, 40 by determination of the relative positions of reference marks 51 and 52. This may be carried out before or after development of the pattern. By determining the offset between adjacent developed patterns 30, 40 the error in positioning of the substrate table during the step mode can be calculated and the process for manufacturing the following substrate, especially the movement of the substrate W during stepping, can be optimized on this information.

The method can be used as a quality control method when the device to be manufactured extends across several target portions. In this case if a degree of misalignment is detected which would result in a defective device, the layer of exposed radiation-sensitive material can be removed and the process for that layer can be carried out again. In this way, the effort expended in previously deposited layers need not be disguarded and no effort need be expended in subsequent layers when the device would in any case not function due to the misalignment.

As will be appreciated, determination of relative placement of adjacent developed patterns 30, 40 is most accurately achieved if the at least one reference mark 5, 51, 52 of adjacent developed patterns are positioned close to one another. This is achieved by having at least one of the at least one reference mark 5, 51, 52 associated with each edge of the device pattern DP which will, once projected and developed, abut against another edge of the device pattern DP. This may be achieved by providing the device pattern DP with at least two axes of symmetry as regards the reference mark 5. This is illustrated in Figure 2 where it can be seen that at least two such axes 80, 85 exist. If the device pattern DP is rectanglar, it is convenient to position a reference mark 5 midway along each edge and spaced away from the edge though the mark may be positioned anywhere. Of course the reference mark 5 should be positioned in an area of the device pattern DP that contains no actual device details.

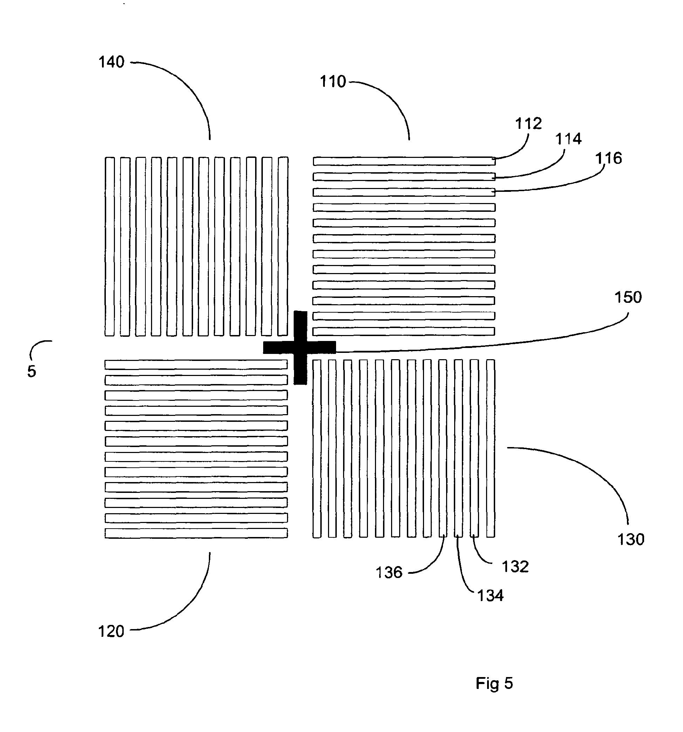

Lithographic projection machines already comprise alignment sensors for precise positioning of various devices such as the mask MA using positioning marks M1, M2 and the substrate W using alignment marks P1, P2. These alignment systems are based on optical defraction methods using defraction gratings. Figure 5 shows a reference mark 5 which may be used in the device pattern DP in the present invention. Existing alignment systems in a lithographic projection apparatus can use such marks 5 to measure relative displacement of developed patterns 10, 20, 30, 40, 50. This pattern of alignment mark is known and it has been explained in detail in WO 98/39689 which also explains on-axis and off-axis alignment using such marks.

Whilst specific embodiments of the invention have been described above, it will be appreciated that the invention may be practiced otherwise than as described. The description is not intended to limit the invention.

## Claims

1. A device manufacturing method comprising the steps of:
- providing a substrate that is at least partly covered by a layer of radiation-sensitive material;
- providing a projection beam of radiation using a radiation system;
- providing at least one patterning means including a device pattern and at least one reference mark;
- using said at least one patterning means to endow the projection beam with said device pattern;
- projecting the patterned beam of radiation onto a plurality of target portions of the layer of radiation sensitive material to create a corresponding pattern in each of said plurality of target portions;
- determining relative placement of two of said corresponding patterns by measuring alignment of said at least one reference mark of said two of said corresponding patterns;
**characterized in that** said at least one reference mark is within said device pattern.

2. A method according to claim 1, wherein said plurality of target portions abut or overlap each other at interfaces, the device pattern projected onto said target portions having at least one of said at least one reference mark associated with each interface.

3. A method according to claim 2, wherein said reference marks are positioned in said pattern such that said pattern has at least two axes of symmetry as regards said reference marks.

4. A method according to any one of the preceding claims, further comprising the step of developing said radiation-sensitive material to form a plurality of developed patterns on said substrate.

5. A method according to any one of the preceding claims, wherein if misalignment is detected in said step of determining, said exposed layer of radiation-sensitive material is removed and the method carried out again.

6. The method of any one of the preceding claims, further comprising the step of optimizing subsequent steps of projecting based on said step of determining.

## Patentansprüche

1. Verfahren zum Herstellen eines Bauelements, umfassend die Schritte:
- Bereitstellen eines Substrats, das zumindest teilweise mit einer Schicht aus strahlungsempfindlichen Material überzogen ist;
- Bereitstellen eines Projektionsstrahls aus Strahlung unter Verwendung eines Strahlungssystems;
- Bereitstellen von zumindest einer Musteraufbringungseinrichtung, die ein Bauelementmuster und zumindest eine Referenzmarkierung umfasst;
- Verwenden der zumindest einen Musteraufbringungseinrichtung, um den Projektionsstrahl mit dem Bauelementmuster zu versehen;
- Projizieren des gemusterten Strahls aus Strahlung auf eine Vielzahl von Zielabschnitten der Schicht aus strahlungsempfindlichen Material, um ein entsprechendes Muster in jedem der Vielzahl von Zielabschnitten zu erzeugen;
- Bestimmen der relativen Anordnung von zwei der entsprechenden Muster, indem die Ausrichtung der zumindest einen Referenzmarkierung der beiden entsprechenden Muster gemessen wird;
**dadurch gekennzeichnet, dass** die zumindest eine Referenzmarkierung innerhalb des Bauelementmusters angeordnet ist.

2. Verfahren nach Anspruch 1, bei dem die Vielzahl von Zielabschnitten an Grenzflächen aneinander angrenzen oder überlappen, und bei dem das auf die Zielabschnitte projizierte Bauelementmuster zumindest eine der zumindest einen Referenzmarkierung aufweist, die jeder Grenzfläche zugeordnet ist.

3. Verfahren nach Anspruch 2, bei dem die Referenzmarkierungen in dem Muster derart angeordnet sind, dass das Muster zumindest zwei Symmetrieachsen bezüglich der Referenzmarkierungen aufweist.

4. Verfahren nach einem der vorhergehenden Ansprüche, des Weiteren mit dem Schritt des Entwickelns des strahlungsempfindlichen Materials, um eine Vielzahl von entwickelten Mustern auf dem Substrat zu bilden.

5. Verfahren nach einem der vorhergehenden Ansprüche, bei dem die belichtete Schicht aus strahlungsempfindlichen Material abgetragen und das Verfahren erneut ausgeführt wird, wenn bei dem Bestimmungsschritt eine Fehlausrichtung erfasst wird.

6. Verfahren nach einem der vorhergehenden Ansprüche, des Weiteren umfassend den Schritt des Optimierens der im Anschluss folgenden Projizierschritte auf Grundlage des Bestimmungsschrittes.

## Revendications

1. Procédé de fabrication de dispositif comprenant les étapes de :
- fournir un substrat qui est au moins partiellement recouvert d'une couche de matériau sensible au rayonnement ;
- fournir un faisceau de projection de rayonnement en utilisant un système de rayonnement ;
- fournir au moins des premiers moyens de mise en forme incluant un motif de dispositif et au moins une marque de référence ;
- utiliser lesdits au moins premiers moyens de mise en forme pour doter le faisceau de projection dudit motif de dispositif ;
- projeter le faisceau de rayonnement mis en forme sur une pluralité de parties cibles de la couche de matériau sensible au rayonnement pour créer un motif correspondant dans chaque partie cible de ladite pluralité de parties cibles ;
- déterminer un placement relatif de deux desdits motifs correspondants en mesurant un alignement de ladite au moins une marque de référence desdits deux desdits motifs correspondants ;
**caractérisé en ce que** ladite au moins une marque de référence est dans ledit motif de dispositif.

2. Procédé selon la revendication 1, dans lequel ladite pluralité de parties cibles viennent en butée les unes contre les autres ou se chevauchent les unes les autres à des interfaces, le motif de dispositif projeté sur lesdites parties cibles ayant au moins une desdites au moins une marque de référence associée à chaque interface.

3. Procédé selon la revendication 2, dans lequel lesdites marques de référence sont positionnées dans ledit motif de telle sorte que ledit motif a au moins deux axes de symétrie en ce qui concerne lesdites marques de référence.

4. Procédé selon l'une quelconque des revendications précédentes, comprenant également l'étape de développer ledit matériau sensible au rayonnement pour former une pluralité de motifs développés sur ledit substrat.

5. Procédé selon l'une quelconque des revendications précédentes, dans lequel si un défaut d'alignement est détecté pendant ladite étape de détermination, ladite couche exposée de matériau sensible au rayonnement est retirée et le procédé est de nouveau mis en oeuvre.

6. Procédé selon l'une quelconque des revendications précédentes, comprenant en outre l'étape d'optimiser des étapes de projection ultérieures sur la base de ladite étape de détermination.
